# EUROPEAN PATENT APPLICATION

(11) **EP 4 425 527 A1**
(43) Date of publication of application: **04.09.2024**
(21) Application number: 22887413.7
(22) Date of filing: 11.10.2022
(51) Int. Cl.: H01H 85/04, H01H 69/02

(54) **FUSE AND METHOD FOR MANUFACTURING SAME**

(30) Priority: 29.10.2021 KR 20210147220
(71) Applicant: LG Energy Solution, Ltd., Seoul 07335 (KR)
(72) Inventor: LEE, Chang Bog, Daejeon 34122 (KR); JUNG, Sang Eun, Daejeon 34122 (KR); KIM, Sung Gyu, Daejeon 34122 (KR)
(74) Representative: Goddar, Heinz J.
(86) International application number: PCT/KR2022/015309
(87) International publication number: WO 2023/075210

(57) **Abstract**

A fuse according to an embodiment disclosed herein includes a printed circuit board (PCB); a conductive pattern disposed on the PCB; a film disposed at opposite lateral sides of the conductive pattern or on the conductive pattern to open at least a partial region above the conductive pattern; and a coating disposed on the conductive pattern and the film.

## Description

### [TECHNICAL FIELD]

### CROSS-REFERENCE TO RELATED APPLICATION

This application claims the priority benefit of the priority based on Korean Patent Application No. 10-2021-0147220, filed October 29, 2021, the disclosure of which is incorporated herein by reference in its entity.

### TECHNICAL FIELD

Embodiments disclosed herein relate to a fuse and a method of fabricating the same.

### [BACKGROUND ART]

Recently, research and development on secondary batteries has been actively conducted. Here, the secondary battery refers to a rechargeable battery, and encompasses both a conventional battery such as a Ni/Cd battery and a Ni/MH battery, and a recent battery such as a lithium-ion battery. Among the secondary batteries, the lithium-ion battery has the advantage of having much higher energy density than the conventional battery such as the Ni/Cd battery and the Ni/MH battery. Further, the lithium-ion battery is used as a power source for a mobile device because it can be made small and lightweight, and has recently attracted attention as a next-generation energy storage medium because its use range has been extended even to power sources for electric vehicles.

In a battery sensing line, a fuse is used to prevent fire and the like problems that may occur due to high voltage. When a sensing line on a printed circuit board (PCB) employs a conductive pattern in the form of accumulating heat, a burn mark is generated in an upper film at a temperature where the conductive pattern works and may make it difficult to secure sufficient insulation resistance even after the conductive pattern is broken.

### [DISCLOSURE]

### [TECHNICAL PROBLEM]

An aspect of embodiments disclosed herein is to provide a fuse, in which a burn mark is less generated in a film on a conductive pattern, and a method of fabricating the same.

An aspect of embodiments disclosed herein is to provide a fuse, in which a film on a conductive pattern is opened to prevent a phenomenon that insulation resistance decreases and to prevent a phenomenon that the conductive pattern swells up in its upper portion by gas generated therein when working, and a method of fabricating the same.

Technical problems of embodiments disclosed herein are not limited to the forementioned technical problems, and other unmentioned technical problems can be clearly understood from the following descriptions by those skilled in art.

### [TECHNICAL SOLUTION]

A fuse according to an embodiment disclosed herein includes a printed circuit board (PCB); a conductive pattern disposed on the PCB; a film disposed at opposite lateral sides of the conductive pattern or on the conductive pattern to open at least a partial region above the conductive pattern; and a coating disposed on the conductive pattern and the film.

According to an embodiment, the coating may include a flame-retardant material.

According to an embodiment, the flame-retardant material may contain a flam-retardant substance of a V0 rating.

According to an embodiment, the at least a partially opened region may have a rectangular or circular shape.

According to an embodiment, the conductive pattern may be formed in zigzags on the PCB to accumulate heat.

According to an embodiment, the film may be disposed being spaced at a distance from the conductive pattern at opposite lateral sides of the conductive pattern.

According to an embodiment, the film may be disposed to at least partially cover opposite upper portions of the conductive pattern.

According to an embodiment, the coating may have adhesive strength set to be physically spaced apart from the conductive pattern upon generating gas between the conductive pattern and the coating.

According to an embodiment, the fuse may further include a dummy region disposed on the film and limiting heat dissipation.

According to an embodiment, the dummy region may contain copper.

According to an embodiment, the dummy region may be disposed in a region other than a region above a melting and breaking portion of the conductive pattern.

A method of fabricating a fuse according to an embodiment disclosed herein includes forming a conductive pattern disposed on a printed circuit board (PCB); forming a film disposed at opposite lateral sides of the conductive pattern or on the conductive pattern to open at least a partial region above the conductive pattern; and forming a coating disposed on the conductive pattern and the film.

### [ADVANTAGEOUS EFFECTS]

In a fuse and a method of fabricating the same according to an embodiment disclosed herein, a partial region above a conductive pattern is opened to prevent a phenomenon that a burn mark is generated in a film and insulation resistance decreases.

In a fuse and a method of fabricating the same according to an embodiment disclosed herein, it is possible to prevent a phenomenon that an upper portion of a conductive pattern swells up due to gas generated therein when the conductive pattern works.

In a fuse and a method of fabricating the same according to an embodiment disclosed herein, an opened region above a conductive pattern is minimized to provide a stable structure for preventing the conductive pattern from moving.

In a fuse and a method of fabricating the same according to an embodiment disclosed herein, a coating having a high flame-retardant rating is used to prevent a fire from breaking out in a PCB when a conductive pattern works.

In a fuse and a method of fabricating the same according to an embodiment disclosed herein, the adhesive strength of a coating is set to physically space the conductive pattern and the coating from each other when the conductive pattern works.

In a fuse and a method of fabricating the same according to an embodiment disclosed herein, a dummy is used on the film to minimize heat dissipation in a region desired to be broken.

Besides, various effects directly or indirectly ascertained through the disclosure may be provided.

### [DESCRIPTION OF DRAWINGS]

FIG. 1 illustrates a fuse according to an embodiment disclosed herein.
FIG. 2 is a block diagram illustrating a cross-section of a fuse according to an embodiment disclosed herein.
FIGS. 3 to 5 are views illustrating an example that an upper portion of a fuse according to an embodiment disclosed herein is opened.
FIG. 6 is a view illustrating a dummy region of a fuse according to an embodiment disclosed herein.
FIG. 7 is a view illustrating a cross-section of a fuse according to another embodiment disclosed herein.
FIG. 8 is a flowchart showing a method of fabricating a fuse according to an embodiment disclosed herein.

### [Mode for Invention]

Hereinafter, embodiments disclosed herein will be described in detail with reference to the accompanying drawings. It should be noted that, in adding reference numerals to the elements in the drawings, like reference numerals designate like elements, even though the elements are shown in different drawings. Further, in describing the embodiments disclosed herein, a detailed description of related well-known features or functions herein may be omitted to avoid obscuring the embodiments disclosed herein.

In describing the elements of the embodiments disclosed herein, terms such as first, second, A, B, (a), (b), and the like may be used. These terms are merely intended to distinguish one element from another element, and the terms do not limit the nature, sequence or order of the elements. Unless otherwise defined, all terms used herein, including technical or scientific terms, have the same meanings as those generally understood by a person having ordinary knowledge in the art to which the embodiments disclosed herein pertain. Such terms as those defined in a generally used dictionary are to be interpreted as having meanings equal to the contextual meanings in the relevant field of art, and are not to be interpreted as having ideal or excessively formal meanings unless clearly defined as having such in the present application.

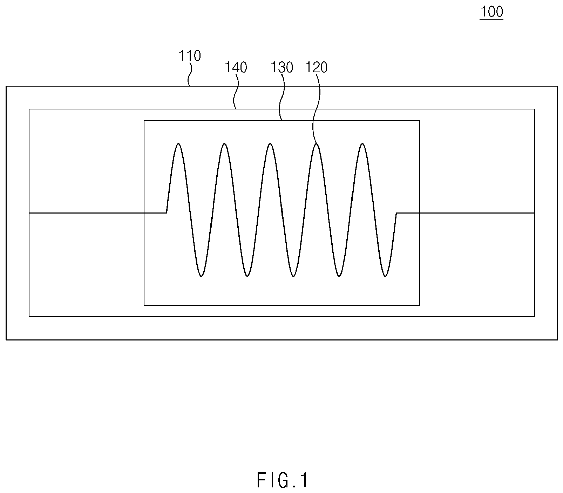

FIG. 1 illustrates a fuse according to an embodiment disclosed herein.

Referring to FIG. 1, the fuse 100 according to an embodiment disclosed herein may include a printed circuit board (PCB) 110, a conductive pattern 120, a film 130, and a coating 140.

The PCB 110 may include a PCB or a flexible printed circuit board (FPCB).

The conductive pattern 120 may be disposed on the PCB 110. For example, the conductive pattern 120 may be formed in zigzags on the PCB 110 so as to accumulate heat. As another example, the conductive pattern 120 may contain copper. In this case, the conductive pattern 120 may work at a temperature of 1,040 degrees or higher. As another example, the conductive pattern 120 may be melt at a set temperature or higher.

The film 130 may be disposed at opposite lateral sides of the conductive pattern 120 or disposed on the conductive pattern 120. The film 130 may be disposed to open at least a partial region above the conductive pattern 120. For example, the film 130 may be disposed being spaced at a distance from the conductive pattern 120 at both lateral sides of the conductive pattern 120. According to an embodiment, the film 130 is disposed to open at least a partial region above the conductive pattern 120, a burn mark may not be formed even when high heat is generated while the conductive pattern 120 is being broken. According to an embodiment, at least a partial region opened on the conductive pattern 120 may be shaped like any one of a quadrangle, a circle, and a polygon.

The coating 140 may be disposed on the conductive pattern 120 and the film 130. For example, the coating 140 may contain a flame-retardant material. According to an embodiment, the flame-retardant material may include a flame-retardant substance of a V0 rating. In other words, the coating 140 can prevent fire (or flame) even though high heat is generated while the conductive pattern 120 is working. The coating 140 can cover at least a partial region, opened by the film 130, on the conductive pattern 120

The coating 140 may contain a material having low heat-absorption properties. For example, the coating 140 may employ a material having low heat-absorption properties so that the conductive pattern 120 can be easily broken in a region where the coating 140 is in contact with the conductive pattern 120.

When the conductive pattern 120 works, an upper portion of the conductive pattern 120 may swell up due to gas generated therein. At this time, the coating 140 covering the upper portion of the conductive pattern 120 may prevent the upper portion of the conductive pattern 120 from swelling up.

According to an embodiment, the coating 140 may have adhesive strength set to be physically spaced apart from the conductive pattern 120 when gas is generated between the conductive pattern 120 and the coating 140. For example, when an overcurrent flows in the conductive pattern 120, heat may be transferred to the film 130 and adhesive, thereby generating gas and causing a space between the conductive pattern 120 and the coating 140. To prevent the space due to the gas, the conductive pattern 120 needs to work quickly, and thus the adhesive strength of the coating 140 is set to physically space the coating 140 from the conductive pattern 120 when the overcurrent flows in the conductive pattern 120.

According to an embodiment, the film 130 or the coating 140 may cover the upper portion of the conductive pattern 120, thereby providing a stable structure for preventing the conductive pattern 120 from moving.

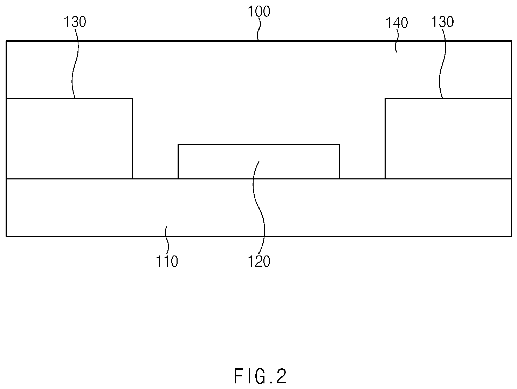

FIG. 2 is a block diagram illustrating a cross-section of a fuse according to an embodiment disclosed herein.

Referring to FIG. 2, the PCB 110 may be disposed beneath the fuse 100.

The conductive pattern 120 may be disposed on the PCB 110. According to an embodiment, the film or the adhesive may be further provided between the PCB 110 and the conductive pattern 120.

The film 130 may be attached to the top of the PCB 110, and disposed to open at least a partial region above the conductive pattern 120. FIG. 2 shows an example that the film 130 is disposed to open the whole region above the conductive pattern 120, but the embodiment is not limited thereto.

The film 130 may be disposed at both lateral sides of the conductive pattern 120. For example, the film 130 may be disposed being spaced at a distance from the conductive pattern 120 at both lateral sides of the conductive pattern 120.

The coating 140 may be disposed to cover the upper portion of the conductive pattern 120 and the film 130. For example, the coating 140 may cover the upper portion of the conductive pattern 120 in the region where the upper portion of the conductive pattern 120 is not covered with the film 130.

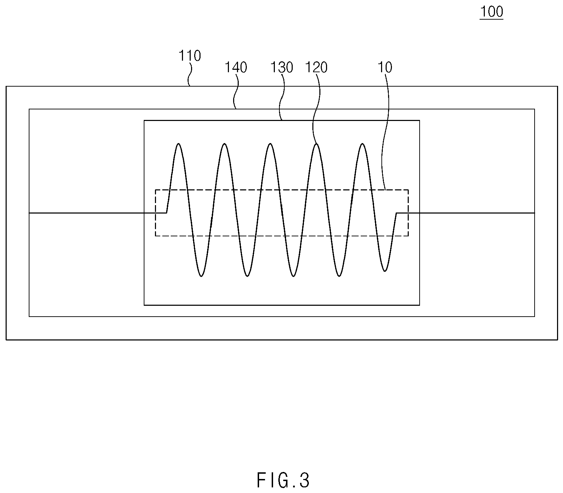

FIGS. 3 to 5 are views illustrating an example that an upper portion of a fuse according to an embodiment disclosed herein is opened.

Referring to FIG. 3, the film 130 included in the fuse 100 according to an embodiment disclosed herein may be disposed to open at least a partial region 10 above the conductive pattern 120. For example, the film 130 may be disposed to open at least a partial region 10 above the conductive pattern 120, and the coating 140 may be disposed to cover the film 130 and the conductive pattern 120.

The partially opened region 10 above the conductive pattern 120 has a rectangular shape. The larger the partially opened region 10, the more difficult it is to fix and stabilize the conductive pattern 120. In other words, when the partially opened region 10 is large, the conductive pattern 120 may move and short-circuit again even after the conductive pattern 120 works to be broken. Therefore, it is required to minimize the partially opened region 10.

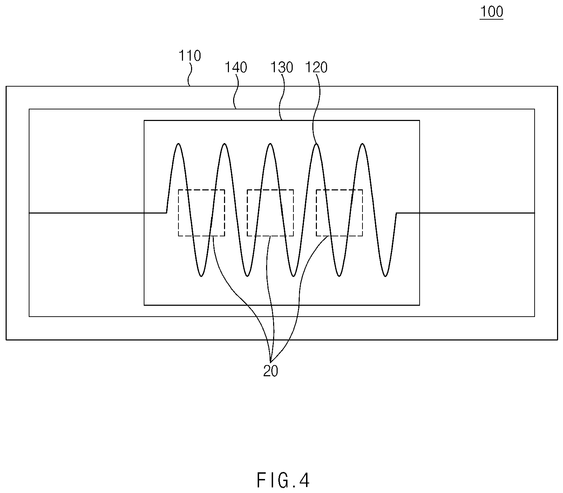

Referring to FIG. 4, the film 130 included in the fuse 100 according to an embodiment disclosed herein may open at least a partial region 20 above the conductive pattern 120. For example, the at least a partial region 20 may have a quadrangular shape.

There may be a plurality of at least partially opened regions 20 above the conductive pattern 120. For example, as shown in FIG. 4, the at least partially opened regions 20 may include a plurality of rectangular regions. As another example, to minimize the partially opened region 20 above the conductive pattern 120, the film 130 may open a partial region above the conductive pattern 120 through the plurality of rectangular regions.

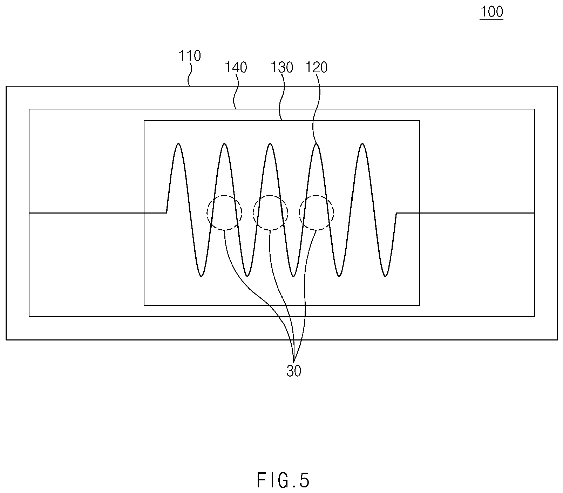

Referring to FIG. 5, the film 130 included in the fuse 100 according to an embodiment disclosed herein may open at least a partial region 20 above the conductive pattern 120. For example, the at least a partial region 20 may have a circular shape.

There may be a plurality of at least partially opened regions 20 above the conductive pattern 120. For example, as shown in FIG. 4, the at least partially opened regions 20 may include a plurality of circular regions. As another example, to minimize the partially opened region 20 above the conductive pattern 120, the film 130 may open a partial region above the conductive pattern 120 through the plurality of circular regions.

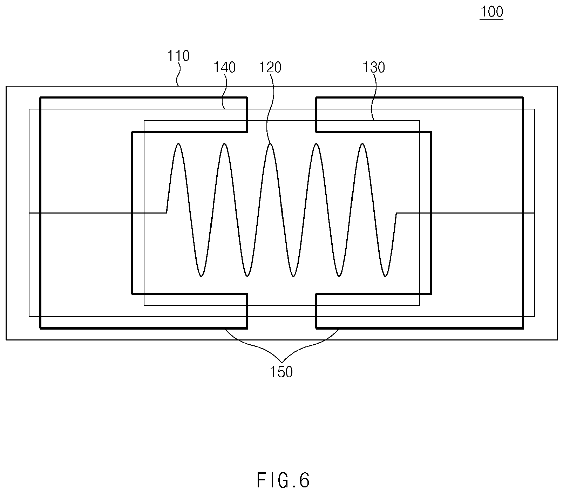

FIG. 6 is a view illustrating a dummy region of a fuse according to an embodiment disclosed herein.

Referring to FIG. 6, the fuse 100 according to an embodiment disclosed herein may further include a dummy region 150.

The dummy region 150 may be disposed on the film 130. For example, the dummy region 150 may be disposed on the film 130 to limit heat dissipation. As another example, the dummy region 150 may be disposed on the film 130 to minimize the heat dissipation. The film 130 may be disposed on the conductive pattern 120, and the dummy region 150 may be disposed on the film 130 and protect the film 130 because the film 130 alone is weak and easy to tear. According to an embodiment, the dummy region 150 may contain copper.

The dummy region 150 may be disposed in a region other than a region above a melting and breaking portion of the conductive pattern 120. For example, the dummy region 150 may be deleted or minimized above the melting and breaking portion of the conductive pattern 120, thereby minimizing heat dissipation. Therefore, the melting and breaking portion of the conductive pattern 120 is highly likely to be broken.

According to an embodiment, the dummy region 150 may have a shape as shown in FIG. 6. However, the dummy region 150 is not limited to this shape, but may have various shapes as long as it is disposed on the film 130 and not disposed above the melting and breaking portion of the conductive pattern 120.

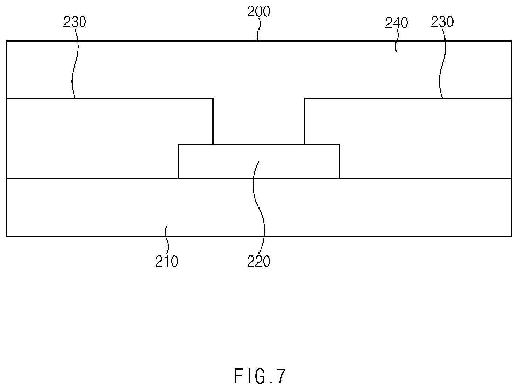

FIG. 7 illustrates a cross-section of a fuse according to another embodiment disclosed herein.

Referring to FIG. 7, a fuse 200 according to another embodiment disclosed herein may include a PCB 210, a conductive pattern 220, a film 230, and a coating 240. According to an embodiment, the PCB 210, the conductive pattern 220, the film 230, and the coating 240 may be substantially the same as the PCB 110, the conductive pattern 120, the film 130 and the coating 140 shown in FIG. 1.

The film 230 may be disposed on the conductive pattern 220 to open a least a partial region above the conductive pattern 220. For example, the film 230 may be disposed to cover opposite upper portions of the conductive pattern 220.

The coating 240 may cover the film 230 and the conductive pattern 220.

According to an embodiment, at least a partial region above the conductive pattern 220 of the fuse 200 shown in FIG. 7 may be opened by the film 230 like that shown in FIGS. 3 to 5.

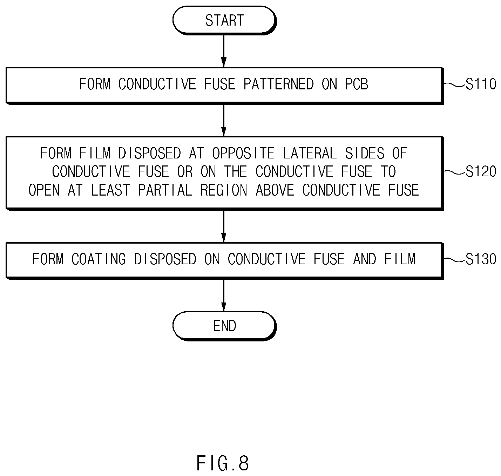

FIG. 8 is a flowchart showing a method of fabricating a fuse according to an embodiment disclosed herein.

Referring to FIG. 8, the method of fabricating the fuse 100 according to an embodiment disclosed herein may include steps of forming a conductive pattern disposed on the PCB (S110), forming a film disposed at opposite lateral sides of the conductive pattern or on the conductive pattern to open at least a partial region above the conductive pattern (S120), and forming a coating disposed on the conductive pattern and the film (S130).

In step S110 of forming the conductive pattern disposed on the PCB, the conductive pattern 120 may be formed to be disposed on the PCB 110. For example, the conductive pattern 120 may be formed in zigzags on the PCB 110 so as to accumulate heat of the PCB 110.

In step S120 of forming the film disposed at both lateral sides of the conductive pattern or on the conductive pattern to open at least a partial region above the conductive pattern, the film 130 may be formed to open at least a partial region above the conductive pattern 120. For example, the film 130 may be disposed at both lateral sides of the conductive pattern 120 or on the conductive pattern 120. As another example, the film 130 may open at least a partial region above the conductive pattern 120 in a rectangular or circular shape.

In step S130 of forming a coating disposed on the conductive pattern and the film, the coating 140 may be formed on the conductive pattern 120 and the film 130. For example, the coating 140 may include a flame-retardant material, and the flame-retardant material may include a flame-retardant substance of a V0 rating. As another example, the coating 140 may have adhesive strength set to be physically spaced apart from the conductive pattern 120 when gas is generated between the conductive pattern 120 and the coating 140

The foregoing description is merely illustrative of the technical idea disclosed herein, and various modifications and variations will be possible without departing from the essential characteristics of the embodiments disclosed herein by a person having ordinary knowledge in the art to which the embodiments disclosed herein pertain.

Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

## Claims

1. A fuse comprising:
a printed circuit board (PCB);
a conductive pattern disposed on the PCB;
a film disposed at opposite lateral sides of the conductive pattern or on the conductive pattern to open at least a partial region above the conductive pattern; and
a coating disposed on the conductive pattern and the film.

2. The fuse of claim 1, wherein the coating comprises a flame-retardant material.

3. The fuse of claim 2, wherein the flame-retardant material contains a flam-retardant substance of a V0 rating.

4. The fuse of claim 1, wherein the at least a partially opened region has a rectangular or circular shape.

5. The fuse of claim 1, wherein the conductive pattern is formed in zigzags on the PCB to accumulate heat.

6. The fuse of claim 1, wherein the film is disposed being spaced at a distance from the conductive pattern at opposite lateral sides of the conductive pattern.

7. The fuse of claim 1, wherein the film is disposed to at least partially cover opposite upper portions of the conductive pattern.

8. The fuse of claim 1, wherein the coating has adhesive strength set to be physically spaced apart from the conductive pattern upon generating gas between the conductive pattern and the coating.

9. The fuse of claim 1, further comprising a dummy region disposed on the film and limiting heat dissipation.

10. The fuse of claim 9, wherein the dummy region contains copper.

11. The fuse of claim 9, wherein the dummy region is disposed in a region other than a region above a melting and breaking portion of the conductive pattern.

12. The fuse of claim 1, wherein the PCB comprises a PCB or a flexible printed circuit board (FPCB).

13. A method of fabricating a fuse, comprising:
forming a conductive pattern disposed on a printed circuit board (PCB);
forming a film disposed at opposite lateral sides of the conductive pattern or on the conductive pattern to open at least a partial region above the conductive pattern; and
forming a coating disposed on the conductive pattern and the film.
